# EUROPEAN PATENT SPECIFICATION

(11) **EP 0 430 204 B1**
(45) Date of publication and mention of the grant of the patent: **05.06.1996**
(21) Application number: 90122742.1
(22) Date of filing: 28.11.1990
(51) Int. Cl.: H01L 23/495

(54) **Plastic mould type semiconductor device**
Kunststoffumhüllte Halbleiteranordnung
Dispositif semi-conducteur du type à encapsulation en plastique

(30) Priority: 28.11.1989 JP 306606/89
(43) Date of publication of application: 05.06.1991
(73) Proprietor: KABUSHIKI KAISHA TOSHIBA, Kawasaki-shi, Kanagawa-ken 210 (JP)
(72) Inventor: Ishikawa, Toshimitsu, 320 Toshiba-Shinkoyasu, Yokohama-Shi, Kanagawa-Ken (JP); Komenaka, Kazuichi, Kawasaki-Shi, Kanagawa-Ken (JP)
(74) Representative: Lehn, Werner, Dipl.-Ing.

(56) References cited:
- EP-A- 0 410 116
- PATENT ABSTRACTS OF JAPAN vol. 12, no. 193 (E-617) 04 June 1988,& JP-A-62 296541 (MATSUSHITA ELECTRONICS CORP) 23 December 1987,
- PATENT ABSTRACTS OF JAPAN vol. 13, no. 181 (E-750) 27 April 1989,& JP-A-1007628 (HITACHI LTD) 11 January 1989,

## Description

This invention relates to a plastic mold type semiconductor device assembly comprising a semiconductor chip mounted on a bed, leads of a lead frame, each lead having an inner lead portion arranged above the upper surface of said semiconductor chip and an outer lead portion extending away from said semiconductor chip, bonding wires connecting bonding pads on said upper surface of said semiconductor chip to bonding portions of said leads, and a plastic material encasing said semiconductor chip, said bed, said inner lead portions of said leads and said bonding wires. Such an assembly is described in JP-A-1 007 628.

Another semiconductor device assembly is illustrated in JP-A-62 296 541. In this assembly bonding wires from a chip are connected to leads of a lead frame at bonding portions which are positioned laterally outside the chip. EP-A-0 410 116 (a reference under Art 54(3) EPC) describes another semiconductor device with lead frames.

Sealing or molding in semiconductor devices, such as ICs, and LSIs, is carried out in order to protect semiconductor chips from pollution source such as dust, chemicals, gas or moisture, and mechanical breakage exerting bad influences on those elements. As this protecting method, hermetic sealing and plastic molding are generally used. Resin or plastic material used in this sealing or molding is closely in contact with the element surface and completely covers thereover. Semiconductor devices protected by plastic material or resin are referred to as a plastic mold type semiconductor device.

As the semiconductor devices of this kind, there are known semiconductor devices of the DIP (Dual Inline Package) type in which two rows of lead pins are arranged in parallel, semiconductor devices of the SIL type in which a single row of lead pins are linearly arranged. A conventional plastic mold type semiconductor device will be described by taking an example of a DIP type semiconductor device.

A semiconductor chip is mounted on an element mounting portion at the central portion of a lead frame having a flat smooth surface and front end portions of a plurality of leads arranged so as to surround the element mounting portion. The leads are connected by means of bonding wires. Thereafter, by transferring plastic material into a cavity or hollow portion with the lead frame being held between the upper and lower molds in order that the semiconductor chip is positioned, e.g., at the central portion of the Cavity formed on the contact surface of the upper and lower molds to fill the cavity with plastic material, the semiconductor chip mounted on the element mounting porticn, bonding wires and inner end portions of leads, etc. are embedded into a plastic mold in a predetermined form and sealed. In this case, the following technique is typically employed. At the peripheral portion of the cavity formed on the contact surface of the upper and lower molds, plastic material filled into gaps between a plurality of adjacent leads is intercepted by a dam bar surrounding the outer peripheral portion of the cavity at a predetermined interval to connect the plurality of leads. The semiconductor chip is bonded onto the chip mounting portion (bed) by a conductive adhesive agent such as solder, gold, or plastic material, etc. After the plastic material is filled, the lead frame portion located outside of the molded resin is reformed. That is, an unnecessary portion including the dam bar is cut off and removed. Thus, a plastic mold type semiconductor device of the DIP type is provided.

In recent years, with high density integration of semiconductor elements, semiconductor chips tend to become large in dimension. On the contrary, not only plastic mold type semiconductor devices but also semiconductor devices of other types are strongly required to be miniaturized similarly to other electronic parts. Accordingly, the package size is maintained at an existing size, or must be as small as possible. As a result, the size of the package becomes extremely close to that of the semiconductor chip, so the inner lead portion of the lead, which is ordinarily sealed with a molded plastic material, cannot take a sufficient molding length within the molded plastic material. For this reason, since the strength cannot be increased, many troubles may occur such that leads are drawn or pulled out at the succeeding process after the formation of mold.

For a measure to reduce occurrence of such troubles, an arrangement is proposed to elongate the inner lead up to the portion above the semiconductor chip. When the lead is arranged as above, the portion coated with the molded plastic material is elongated.

However, even in the case of employing this structure, since the inner lead portion is positioned above the chip, it may be easily moved toward the surface of the chip even if a small force is applied thereto. At the wire bonding process, the inner lead portion of the lead is pressed toward the semiconductor chip at the time of bonding. At this time, if any foreign substance such as dust is present on the semiconductor chip, such foreign material will be put between the semiconductor chip and the inner lead portion, with the result that the semiconductor is scratched or damaged due to the pressure to the upper surface of the inner lead at the wire bonding. As dust actually conceivable, in the case where the substrate of the semiconductor chip is silicon, silicon particle is assumed.

An object of this invention is to provide a plastic mold type semiconductor device such that the inner lead can take a sufficient molding length within the molded plastic material even if the size of the semiconductor chip becomes extremely close to the size of the package, thus making it possible to prevent the lead from being pulled out, the semiconductor device being further adapted to be free from the damage of the semiconductor chip produced resulting from the fact that any foreign material is put between the inner lead and the semiconductor chip at the time of wire bonding.

According to the present invention, the assembly initially defined is characterized in that each of said inner lead portions has an end portion of enlarged width, and in that each of said bonding portions is positioned laterally outside said semiconductor chip and spaced from the respective inner lead portion.

In the accompanying drawings:
FIG. 1 is a plan view of a plastic mold type semiconductor device of an embodiment according to this invention, and
FIG. 2 is a cross-sectional view taken along the A-A' line of FIG. 1.

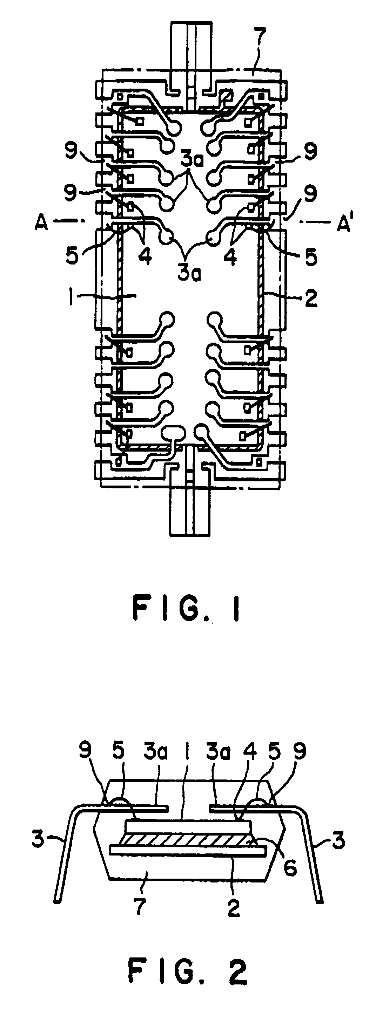

A preferred embodiment of this invention will now be described with reference to FIGS. 1 and 2.

FIG. 1 is a plan view showing a plastic mold type semiconductor device of the DIP type, and FIG. 2 is a cross-sectional view taken along the line A-A' thereof.

In this embodiment, in addition to the lead frame, another frame for mounting a chip (hereinafter referred to as a "bed frame") is used. Initially, e.g., a semiconductor chip 1 such as an LSI is mounted on a chip mounting portion 2 of the bed frame, and is fixed thereon by means of a conductive bonding material. As the bonding material, e.g., epoxy resin containing metal powder, solder, or gold, may be used. The bed frame is arranged with the side where the chip 1 is provided facing the lead frame. By holding and fixing both frames as they are, the inner lead portions of leads 3 of the lead frame are arranged above the upper surface of the semiconductor chip 1 so as to face the chip 1. The chip 1 and the leads 3 are electrically connected by bonding wires 5, e.g., gold wires, etc. The bonding wires 5 are connected to bonding pads 4 of the semiconductor chip 1 and the bonding portions 9 of the leads 3, respectively.

The inner end portion 3a of the inner lead portion of each lead 3 is bent and widened so as to take a circular form.

For connection of the leads 3 and the bonding pads 4, any suitable wire bonding method may be selected; e.g. the wire bonding method implemented with the application of load and ultrasonic wave energy to the object to be connected, (which is usually used in the case where the bonding wire is an aluminium wire; and is ordinarily implemented at an ordinary temperature;) or the thermo-compression bonding method, (which is chiefly used for gold wire), in which wire bonding is carried out by utilizing pressure, heat and ultrasonic vibration.

Irrespective of the method selected, since the bonding portions 9 of the leads 3 are spaced from the semiconductor chip 1 and are away from the portion above the semiconductor chip 1, even if any bonding portion 9 is pressed downwardly, there is no possibility that the bonding portions 9 come close to the chip 1 to such an extent that bad influence is exerted on the chip 1. Further, there is no possibility that the front end portions 3a of the leads above the chip come too close to the chip.

After the wire bonding process is completed, the process step shifts to the process for implementing plastic molding of the semiconductor chip.

As the plastic molding method, there are enumerated the potting method, the transfer molding method, the casting method, etc. An arbitrary method may be selected. In this embodiment, the transfer molding method of low cost and excellent mass-productivity is used. Although this method requires large initial investment for equipment, plastic moldings of constant quality can be mass-produced without damaging the characteristics of the wires, the frames and the semiconductor chips if pouring of plastic into a metal mold is carried out at a low speed. In a more practical sense, there is implemented a method of allowing powdered plastic material or plastic material in the form of tablets to melt by applying temperature and pressure thereto to pour it into the metal mold to solidify it. As the plastic material 7, epoxy resin may be used. As the curing or hardening agent, agent of acid anhydride, amine, or phenol, etc. may be used. in this case, the molding condition is as follows: temperature of about 160 to 180°C, pressure of about 49 to 98 MPa, and molding time of about 60 to 120 seconds. Thereafter, postcuring is carried out for several hours at a temperature of about 150 to 180°C. Thus, the plastic molding process is completed.

After the plastic molding process is completed, plastic material burrs produced on the lead frame in implementation of this process are removed by suitable means. Then, processing such as solder-plating, etc. is implemented to the lead frame, and lead processing, etc. is carried out. Thus, a plastic mold type semiconductor device of the DIP type is completed.

While explanation has been given in connection with the plastic mold type semiconductor device of the DIP type in the above-described embodiment, this invention is not limited to such an implementation, but is applicable to various semiconductor devices such as the semiconductor device of the SIL type, etc.

In addition, while the front end portion of the inner lead is formed circular at the inside thereof in the above-describec embodiment, this invention is not limited to such an implementation. As long as the inner lead is of a structure enlarged in width, pulling-out of the inner lead is advantageously prevented.

In accordance with the plastic mold type semiconductor device hereinbefore described, even if the size of the semiconductor chip and that of the envelope are extremely close to each other, the lead can take a sufficient length within the molded plastic material, resulting in no possibility that the lead may be pulled out. Further, since the bonding portion of the lead is formed at the portion except for the extending portion, i.e., spaced from the portion above the semiconductor chip, the device is permitted to be free from the damage exerted on the semiconductor chip resulting from any foreign material which is present between the lead and the semiconductor chip and pressed to the upper surface of the inner lead at the time of wire bonding, resulting in an improved product yield.

Reference signs in the claims are intended for better understanding and shall not limit the scope.

## Claims

1. A plastic mold type semiconductor device assembly comprising a semiconductor chip (1) mounted on a bed (2), leads (3) of a lead frame, each lead (3) having an inner lead portion arranged above the upper surface of said semiconductor chip (1) and an outer lead portion extending away from said semiconductor chip (1), bonding wires (5) connecting bonding pads (4) on said upper surface of said semiconductor chip (1) to bonding portions (9) of said leads (3), and a plastic material (7) encasing said semiconductor chip (1), said bed (2), said inner lead portions of said leads (3) and said bonding wires (5), characterized in that each of said inner lead portions has an end portion (3a) of enlarged width, and in that each of said bonding portions (9) is positioned laterally outside said semiconductor chip (1) and spaced from the respective inner lead portion.

2. A semiconductor device assembly as set forth in claim 1, wherein said end portions (3a) of enlarged width have a circular form.

## Patentansprüche

1. Halbleitervorrichtungsmontage des Kunstharzgießtyps, aufweisend: einen Halbleiterchip (1), der auf einem Bett (2) montiert ist; Anschlußleiter (3) eines Systemträgers, wobei jeder Anschlußleiter (3) einen inneren Leiterabschnitt besitzt, der über der oberen Oberfläche des Halbleiterchips (1) angeordnet ist, und der einen äußeren Leiterabschnitt aufweist, der sich vom Halbleiterchip (1) weg erstreckt; Bondierungsdrähte (5), die die Bondierungsflecken (4) auf der genannten oberen Oberfläche des Halbleiterchips (1) mit Bondierungsabschnitten (9) der genannten Anschlußleiter (3) verbinden; und ein Kunstharzmaterial (7), das den Halbleiterchip (1), das genannte Bett (2), die genannten inneren Leiterabschnitte der Anschlußleiter (3) und die Bondierungsdrähte (5) umschließen,
dadurch **gekennzeichnet**, daß jeder der inneren Leiterabschnitte einen Endabschnitt (3a) vergrößerter Breite aufweist, und daß jeder der Bondierabschnitte (9) seitlich außerhalb des Halbleiterchips (1) angeordnet und gegen den jeweiligen inneren Leiterabschnitt beabstandet ist.

2. Halbleitervorrichtungsmontage nach Anspruch 1, bei der der Endabschnitt (3a) vergrößerter Breite Kreisform besitzt.

## Revendications

1. Assemblage de dispositif à semiconducteur du type à moulage plastique, comprenant une puce semiconductrice (1) montée sur un socle (2), des connexions (3) d'une grille de connexion, chaque connexion (3) comprenant une partie de connexion interne agencée au-dessus d'une surface supérieure de ladite puce semiconductrice (1) et une partie de connexion externe s'étendant de façon à être éloignée de ladite puce semiconductrice (1), des fils de liaison (5) connectant des plots de liaison (4) sur ladite surface supérieure de ladite puce semiconductrice (1) pour relier des parties (9) desdites connexions (3), et une matière plastique (7) encapsulant ladite puce semiconductrice (1), ledit socle (2), lesdites parties de connexion interne desdites connexions (3) et lesdits fils de liaison (5), caractérisé en ce que chacune desdites parties de connexion interne comprend une partie d'extrémité (3a) d'une largeur augmentée, et en ce que chacune desdites parties de liaison (9) est positionnée latéralement à l'extérieur de ladite puce semiconductrice (1) et est espacée de ladite partie de connexion interne respective.

2. Assemblage de dispositif à semiconducteur selon la revendication 1, dans lequel lesdites parties d'extrémité (3a) de largeur augmentée ont une forme circulaire.
